**Europäisches Patentamt**

**European Patent Office**

**Office européen des brevets**

(19)

(11) Veröffentlichungsnummer : **0 475 188 B1**

(12) # EUROPÄISCHE PATENTSCHRIFT

(45) Veröffentlichungstag der Patentschrift :
08.11.95 Patentblatt 95/45

(51) Int. Cl.⁶ : **H03G 3/34**

(21) Anmeldenummer : **91114368.3**

(22) Anmeldetag : **27.08.91**

(54) **Verfahren und Vorrichtung zur Minimierung von Störungen beim FM- oder PM-Empfang.**

(30) Priorität : **11.09.90 DE 4028768**

(43) Veröffentlichungstag der Anmeldung :
**18.03.92 Patentblatt 92/12**

(45) Bekanntmachung des Hinweises auf die
Patenterteilung :
**08.11.95 Patentblatt 95/45**

(84) Benannte Vertragsstaaten :
**DE ES FR GB IT**

(56) Entgegenhaltungen :
**EP-A- 0 099 760**
**PATENT ABSTRACTS OF JAPAN vol.9, no. 23**
**(E-293)30. January 1985 & JP-A-59 168 725**

(73) Patentinhaber : **Brinkhaus, Stefan**
**Hans-Thoma-Strasse 13**
**D-75196 Remchingen (DE)**

(72) Erfinder : **Brinkhaus, Stefan**
**Hans-Thoma-Strasse 13**
**D-75196 Remchingen (DE)**

(74) Vertreter : **Frank, Gerhard, Dipl.-Phys. et al**
**Patentanwälte**
**Mayer, Frank, Reinhardt,**
**Westliche 24**
**D-75172 Pforzheim (DE)**

EP 0 475 188 B1

## Beschreibung

Die Erfindung betrifft ein Verfahren und eine Vorrichtung zur Minimierung von Störungen beim FM- oder PM-Empfang gemäß dem Oberbegriff der Patentansprüche 1 und 6.

Die bei einem FM-Empfänger, insbesondere einem nicht-stationär betriebenen Empfänger, wie beispielsweise einem Autoradio, auftretenden Empfangsstörungen beruhen auf vielfältigen Störsignalen, beispielsweise durch Gleichkanal- und Nachbarkanal-Empfang und Rauschen als auch Multipath- und Fremdstörungen, letztere beispielsweise auch durch Computer oder Industrieanlagen verursacht. Solange die Amplituden der Störfrequenz(en) unterhalb einer bestimmten Schwelle bleiben, werden sie durch die übliche Technik (Begrenzerverstärker und begrenzender Demodulator) zusätzlich unterdrückt; erreichen sie jedoch vergleichbare Größenordnungen wie die Amplituden des Nutzsignals, so treten starke Amplitudenschwankungen durch Signalüberlagerungen (als Schwebung bekannt) und zugleich extreme Phasenmodulation auf. Grundsätzlich gilt dies auch für PM (Phasenmodulationsempfänger), soll hier jedoch am Beispiel des FM-Empfängers beschrieben werden.

Es gibt daher verschiedene Versuche, durch geeignete schaltungstechnische Maßnahmen bzw. geeignete Verfahren das Vorliegen einer Störungskomponente im empfangenen Gesamtsignal aufzuspüren und (wegen der Unmöglichkeit der Elimination des Störsignals wegen der nichtlinearen Charakteristiken in der Schaltung) zumindest während der Zeitabschnitte maximaler Störung das ausgangsseitige Gesamtsignal zu korrigieren und dadurch zumindest näherungsweise das Störsignal in diesen kritischen Zeitabschnitten weitgehend zu eliminieren, zumindest so weit, daß der Höreindruck spürbar gebessert wird.

Ein derartiges "Entstörungssystem" und dessen Grundlage im Stand der Technik ist beispielsweise in der DE-A- 39 16 789 beschrieben:

Bei diesem Entstörungssystem wird eine Störkomponente aus einem FM-Demodulationssignal mit Hilfe einer Entstörungseinrichtung ausgefiltert und nach weiterer Verarbeitung wird mit Hilfe eines Steuersignalgenerators ein Aus-Steuersignal erzeugt, das die Unterbrechung der Übertragung des FM-Demodulationssignals bzw. des FM-Detektorsignals auf die nachfolgende Stufe bewirkt. Hierbei kann die Schwelle bzw. der vorbestimmte Pegel, bei dem dieser Steuersignalgenerator anspricht, automatisch durch den empfangenen Störungspegel, der im FM-Demodulationssignal enthalten ist, vorgegeben werden. Während einer bestimmten Zeitdauer (Korrekturphase) wird bei Betrieb des Steuersignalgenerators mit Hilfe einer Pegelhalteschaltung folglich das MPX-Signal auf dem aktuellen Wert vor dem Aus-Steuersignal des Steuersignalgenerators gehalten, wodurch im Verlauf des MPX-Signals eine stufenartige Charakteristik entsteht durch die Austastung der Störung. Die vorbekannte Vorrichtung erkennt das Vorliegen einer Störung am FM-Demodulationssignal mit Hilfe eines Hochpass-Filters, also am auftretenden Frequenzspektrum. Dadurch kann zwar das Vorhandensein, nicht jedoch Beginn und Dauer einer Phasenstörung exakt definiert werden, so daß Störaustastungen dieser Art üblicherweise feste Austastzeiten verwenden, die auch durch die schaltungstechnischen Eigenschaften, beispielsweise des Hochpasses, in der Regel wesentlich länger sind, als ein Großteil der Störsignale, wie sie beispielsweise von Zündstörungen erzeugt werden. Folglich ist in der DE-A- 39 16 789 auch nicht die Rede von der Dauer des Aus-Steuersignals des Steuersignalgenerators, sondern lediglich von einer "bestimmten Zeitdauer" während der das Aus-Steuersignal gehalten wird.

Die starre Festlegung bzw. schaltungstechnisch bedingte Vorgabe der Austastzeit (also der Korrekturphase) ist zwangsläufig ein Kompromiß bezüglich der üblicherweise oder in überwiegender Anzahl auftretenden Störungen bzw. deren Dauer: Ist die Korrekturphase zu lang, wird ein Teil des Nutzsignals "verschenkt", ist sie zu kurz, ist die Störaustastung bruchstückhaft, ein Teil der Störung gelangt unbeeinflußt ins ausgangsseitige Gesamtsignal. Die frequenzseitige Erfassung der Störung über das Hochpaßfilter ist zwangsläufig sehr vom Frequenzspektrum des Störers abhängig und erfordert auch hier eine Festlegung auf Kompromisse hinsichtlich des Wertes oder des Frequenzspektrums der in Frage kommenden Störsignale.

Dies führt letztendlich dazu, daß manche Störungen ausgetastet werden, andere nicht, andere zu einer unnütz langen Korrekturphase führen. Hierdurch können wiederum Störfolgefrequenzen entstehen (nicht ausgetastete Störsignale und nur teilweise ausgetastete), deren Frequenz in einem niedrigeren Frequenzbereich liegt, als die ursprüngliche Störfolgefrequenz und folglich für den Hörer sehr unangenehm wirkt.

Die in der DE-A- 39 16 789 vorgeschlagene Lösung ist daher in ihrer Reaktion auf die Vielzahl verschiedenster Störsignale lediglich auf die Anpassung des Störsignalpegels beschränkt, ein "individuelles" Eingehen auf das aktuell auftretende Störsignal hinsichtlich des Anfangs und Endes der Austastung bzw. Korrekturphase ist nicht möglich und führt folglich auch nur zu einem teilweise befriedigenden Arbeiten bei Anwendung dieses Verfahrens bzw. der dort vorgeschlagenen Schaltungsmerkmale.

Abweichend von dem oben beschriebenen Verfahren ist es auch grundsätzlich bekannt, zur Identifizierung von Störsignalen innerhalb eines empfangenen Gesamtsignals, den Amplitudenbereich auszuwerten, der gleichzeitig mit einer Störphasenmodulation auftritt (Störphasengang ist die erste Ableitung $d\varphi/dt$ der Störpha-

2

se und diese erscheint letztlich als Störung am Ausgang eines FM-Demodulators): So zeigt beispielsweise die gattungsbildende DE-B- 21 42 172 eine Sperrschaltung, bei der die eingangs geschilderten Probleme der Interferenzstörungen dadurch gelöst werden, daß während der Dauer der Amplitudeneinbrüche mittels einer "Totzonendetektorschaltung" der Niederfrequenzkanal des Empfängers gesperrt wird, wenn das Empfangssignal einen vorbestimmten Einbruchspegel, d.h. einen bestimmten Schwellenwert unterschreitet, wobei über den Wert dieser Schwelle nur gesagt ist, daß sie dann greifen soll, wenn die Signalfeldstärke so weit abfällt, daß "das Nutzsignal im Rauschpegel versinkt". Der Wert des Schwellenwerts ist dabei durch Beeinflussung eines diesbezüglichen Steuersignals von außen einstellbar, bleibt dann aber konstant.

Dieses vorbekannte, gattungsbildende Verfahren hat den Nachteil, daß auch hier die Wahl des Schwellenwertes des Einbruchspegels nur ein unbefriedigender Kompromiß sein kann, da aufgrund der Natur der auftretenden Störungen insbesondere auch solche Störsignale zu extrem schnellen Phasenverschiebungen und somit deutlich hörbaren Verzerrungen führen können, die im Gesamtsignal nur zu absolut geringen Amplitudeneinbrüchen führen, die oberhalb des gesetzten Schwellenwertes bleiben und folglich zu keiner Korrektur wie z.B. Sperrung des Niederfrequenzkanals führen. Insbesondere handelt es sich hierbei um betragsmäßig "kleine", aber sehr steile Amplitudeneinbrüche, die die vorbekannte "Totzonendetektorschaltung" unbehelligt passieren können und die Wirksamkeit dieser Sperrschaltung stark beeinträchtigen.

Ein vergleichbares Verfahren zeigt die EP-A-0099760; hierbei wird versucht, innerhalb der Korrekturzeit das gestörte Signal durch ein "rekonstruiertes" Signal zu ersetzen, wozu Wert und Anstieg des Signals vor der Störung dazu benutzt werden bzw. abgeleitet werden, um ein derartiges "Ersatzsignal" zu bilden. Der Anwendungsbereich dieser Lösung ist auf bestimmte Impuls- bzw. Signalformen beschränkt, die im obigen Absatz geschilderten Nachteile im Hinblick auf die Vielfalt von möglichen Störungen und dereh Verläufen sind auch durch dieses vorbekannte Verfahren nicht zu beseitigen.

Bei einem weiteren Verfahren (DE-A- 34 46 529) wird ebenfalls das gestörte Empfangssignal für die Zeitdauer der erkannten Störung ausgeblendet, wozu aus dem Empfangssignal das Störsignal generiert wird und mit einem Schwellwert verglichen wird; Beginn und Ende der Störung sind somit durch Über- bzw. Unterschreiten dieses Schwellwertes definiert. Hierbei ist eine automatische Anpassung dieses Schwellwerts an die Störungshäufigkeit des Empfangssignals vorgesehen, in dem Sinn, daß mit zunehmender Häufigkeit der Störungen der Schwellwert angehoben wird und die Schaltung somit zunehmend unempfindlicher gegen die Störungen wird, um zumindest noch einen ausreichenden, wenn auch qualitativ unbefriedigenden Empfang zu gewährleisten.

Insbesondere das zuletzt erwähnte Verfahren macht deutlich, daß bei dem Problem der Interferenzstörungen und der durch diese verursachten Verzerrungen durch Phasenänderungen durch Einführung eines konstanten oder auch sich automatisch anpassenden Schwellenwertes zur Definition der Korrekturphase alleine bestenfalls eine statistische Verbesserung der Qualität des Ausgangssignals erzielbar ist.

Auf die Einzelstörung bezogen, stellt sich die bei den bekannten Verfahren jeweils definierte Korrekturphase als unzureichend dar, da ihre Dauer auf die Dauer der individuellen Störung nur unzureichend angepaßt ist und somit Qualitätsverbesserungen beim Ausgangssignal nur mit erheblichen Einschränkungen erzielbar sind.

Es ist daher Aufgabe der Erfindung, das gattungsgemäße Verfahren so zu verbessern, daß Störsignale verschiedenster Art und Zusammensetzung zuverlässig aus dem empfangenen Gesamtsignal eliminiert werden.

Erfindungsgemäß wird dies durch die Maßnahmen des Patentanspruchs 1 erreicht.

Eine Vorrichtung zu Durchführung dieses Verfahrens ist im Patentanspruch 6 angegeben.

Die grundlegende Erkenntnis des erfindungsgemäßen Verfahrens besteht darin, daß aus der Form, insbesondere der Flankensteilheit und der Tiefe der Amplitudeneinbrüche relativ zum Bezugspegel auf dem Signalweg des Gesamtsignals durch die Schaltungsbstandteile des FM-Empfängers eine individuelle Festlegung des Schwellenwertes und damit der Dauer, insbesondere also auch hinsichtlich eines definierten Anfangs und Endes der Korrekturphase möglich ist. Als Signal kann hier beispielsweise das Feldstärkesignal des ZF-Bausteins verwendet, es kann aber auch beispielsweise die Hüllkurve des ZF-Signals selbst zur Auswertung herangezogen werden.

Ausgehend von dem erfindungsgemäßen Austastkriterium ergibt sich bei FM-Empfängern also beispielsweise die Möglichkeit, entweder im demodulierten Signal bei Verwendung herkömmlicher Begrenzersysteme den Anteil mit maximalem Störphasengang auszublenden, oder durch Verwendung eines weitgehend linearen Verstärkers die Demodulation des Signals im Bereich extremen Störphasenganges von vornherein zu verhindern. Beide Möglichkeiten haben ihre spezifischen Vor- und Nachteile und anhand von Blockschaltbildern werden diese beiden Ausführungsbeispiele zur Realisierung des erfindungsgemäßen Verfahrens erläutert.

Es zeigen:

Figur 1:        Ein Blockschaltbild des ersten Ausführungsbeispiels zur Durchführung des Verfahrens,

Figur 1A und 1B: Ausführungsformen des Schaltungsteils SH der Fig. 1,

Figur 2: eine Darstellung der in einzelnen Abschnitten des Blockschaltbildes gemäß Figur 1 auftretenden Signalformen,

Figur 3: ein Blockschaltbild eines zweiten Ausführungsbeispieles zur Durchführung des erfindungsgemäßen Verfahrens,

Figur 3A: eine Variante des zweiten Ausführungsbeispiels gemäß Figur 3,

Figur 4: eine Darstellung der in Abschnitten des Blockschaltbildes der Figur 3 auftretenden Signalformen,

Figur 5: ein Blockschaltbild zur Kombination beider Schaltungsprinzipien gemäß Figur 1 und 3,

Figur 6: ein Ausführungsbeispiel eines AM-Modulators zum Einsatz in der Schaltung gemäß Figur 3, und

Figur 7: ein Ausführungsbeispiel eines quasi-Linear-Verstärkers zum Einsatz in der Schaltung nach Figur 3.

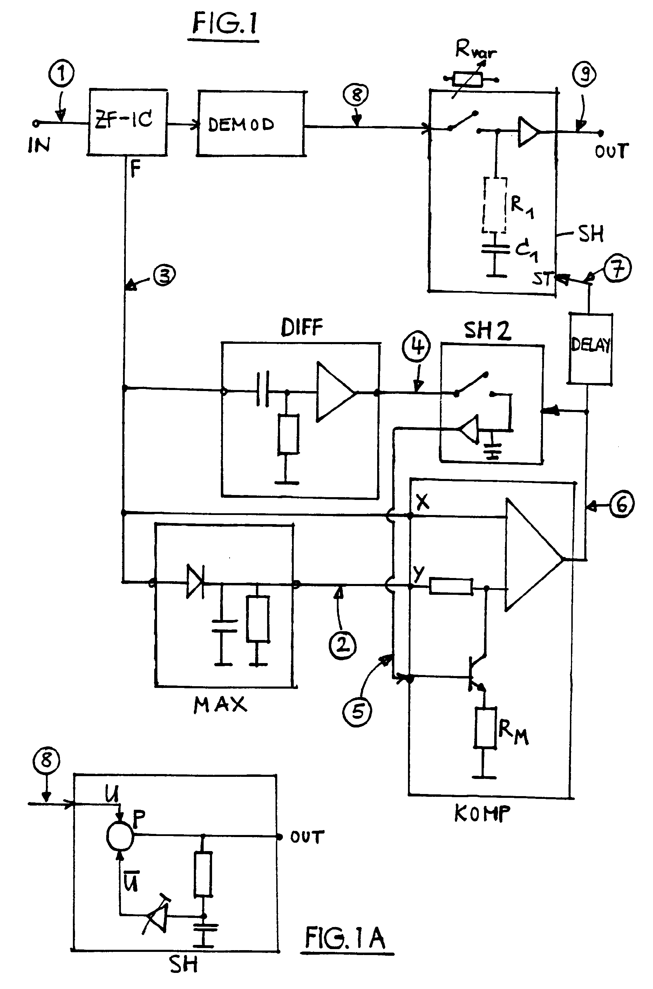

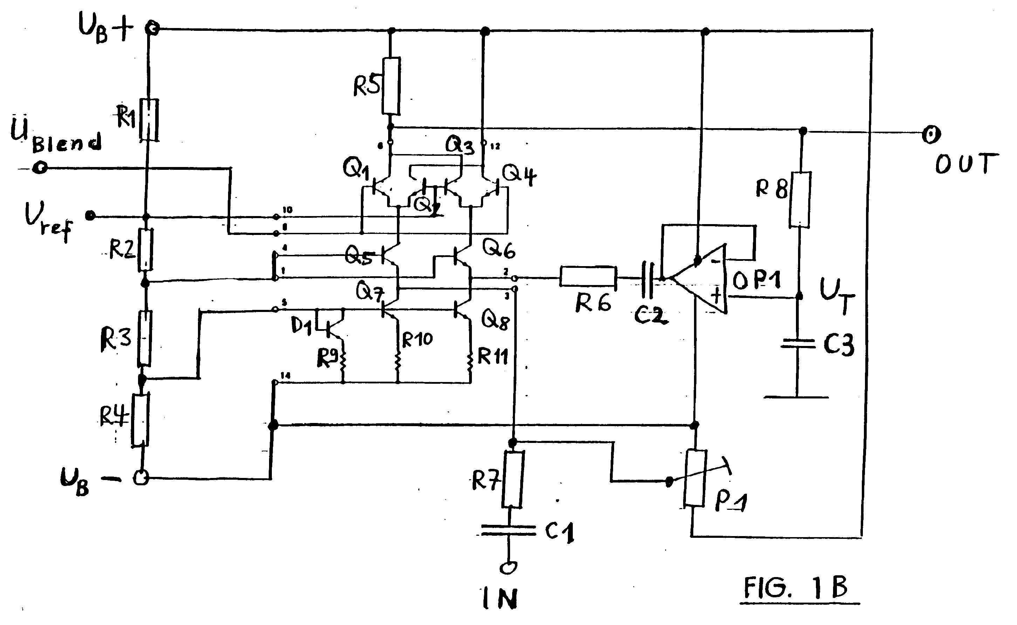

Die in Figur 1 anhand eines Blockschaltbildes skizzierte Schaltung besteht aus der Zwischenfrequenzschaltung ZF-IC mit dem Signaleingang IN und einem Feldstärkeausgang F, einer nachgeschalteten Demodulationsschaltung DEMOD und einer "Sample and Hold"-Schaltung SH.

Parallel zum Feldstärkeausgang F und dem Steuereingang R der Sample-and-Hold Schaltung liegen diejenigen Bauteile, die aus dem Feldstärkesignal des ZF-IC das Steuersignal zur Ansteuerung der Sample-and-Hold Schaltung SH gewinnen, hierbei handelt es sich um folgende Bauteile:

Eine Maximalwertschaltung MAX hält das am Feldstärkeausgang anstehende Signal F mit einer durch den RC-Wert definierten Zeitkonstanten $\tau$ auf dem jeweils aktuellen Maximalwert $M^{(t)}$. Dieser Maximalwert $M^{(t)}$ bildet den Bezugspegel und liegt an einem Eingang y eines Komparators KOMP.

Am anderen Eingang x liegt das aktuelle Feldstärkesignal.

Der Komparator KOMP ist nun so beschaltet, daß er ein Ausgangssignal als Steuersignal für die Korrekturphase dann abgibt, wenn der am Eingang x anliegende aktuelle Feldstärkewert um einen vorgebbaren Schwellenwert $\Delta M$ unter dem am Eingang y anliegenden Maximalwert M liegt; der Komparator KOMP erkennt folglich, wenn bei einem Amplitudeneinbruch die Tiefe des Amplitudeneinbruchs den Wert $\Delta M$ erreicht hat; der Wert $\Delta M$ ist über $R_M$ einstellbar und steuert so den dem Komparatoreingang y aufgeprägten Strom.

Erfindungsgemäß wird nun zusätzlich der Schwellenwert $\Delta M$ in Abhängigkeit vom jeweiligen Amplitudeneinbruch individuell definiert bzw. automatisch neu eingestellt:

Ein Maß für die Amplitude der Störphase ist die Steilheit des Amplitudeneinbruchs, daher läßt sich durch Differenzieren des Feldstärkesignals bei einem Amplitudeneinbruch sehr gut ein sinnvoller Zeitpunkt des Anfangs und des Endes der Störsignalausblendung bestimmen; hierzu dient eine Differenzierschaltung DIFF, die über eine zweite Sample-and-Holdschaltung SH2 den Komparator KOMP ansteuert. Die Differenzierschaltung erzeugt ein Ausgangssignal, das proportional zur Steigung bzw. Abfall der Flanke des Amplitudeneinbruchs ist; der Momentanwert dieses Signals (d.h. bei Erreichen der Schaltschwelle) wird von der Sample-and-Hold-Schaltung SH2 gehalten. Mit zunehmender Steilheit des Flankenabfalls verringert dieses Signal folglich den Wert $\Delta M$, in dem es an der Beschaltung des Eingangs y des Komparators KOMP angreift, um einen Wert $\Delta M_i$ proportional zur Steilheit der Abfallflanke, wobei mit dem Index "i" die laufende Nummer des Amplitudeneinbruchs (Störung) $S_i$ bezeichnet sein soll. Die Wirkung dieser Schaltung besteht kurz gesagt also darin, daß sich jeder Amplitudeneinbruch "seine" Schaltschwelle $E_i$ "selbst" bildet und somit "seine" Korrekturphase hinsichtlich Anfang und Ende individuell definiert.

Unterschreitet nun der am Eingang x des Komparators anliegende Momentanwert des Feldstärkesignals den am Eingang y anliegenden Maximalwert M(t) um den derart gebildeten Schwellenwert $E_i = \Delta M - \Delta M_i$; so gibt der Komparator KOMP ein Steuersignal ab, das über eine Verzögerungsschaltung DELAY zum Steuereingang R der Sample-and-Hold-Schaltung SH gelangt und diese solange aktiviert, bis der Schwellenwert $E_i$ wieder unterschritten wird und der Komparator KOMP wieder "zurückschaltet". Solange hält das vom Komparator KOMP kommende Signal auch die Sample-and-Hold-Schaltung SH2: Wenn die Schwelle $E_i$ wieder unterschritten ist, wird SH2 wieder "geschlossen" und somit auch der Schwellenwert $E_i$ im Komparator KOMP wieder auf seinen Basiswert $\Delta M$ zurückgesetzt, in "Erwartung" des nächsten Amplitudeneinbruchs.

Der Schwellenwert des Komparators KOMP zur Bestimmung des Ausblendzeitpunktes benötigt einen bestimmten Bezugspegel (Maximalwert) des Signals am Feldstärkeausgang, da das Verhältnis Maximalwert M/Schaltschwelle (M−$\Delta M + M_i$) ausschlaggebend für die Funktion der Schaltung ist. Einfach läßt sich dies erreichen, wenn man den bei den meisten ZF-ICs vorhandenen logarithmischen Feldstärkeausgang heranzieht: hier erzeugt jeder Spannungseinbruch unabhängig vom Absolutwert des Pegels einen "dB-proportionalen" Spannungsabfall; legt man letztere Spannung an den Komparator KOMP, erhält man ohne zusätzlichen Aufwand automatisch den "richtigen" Schwellenwert.

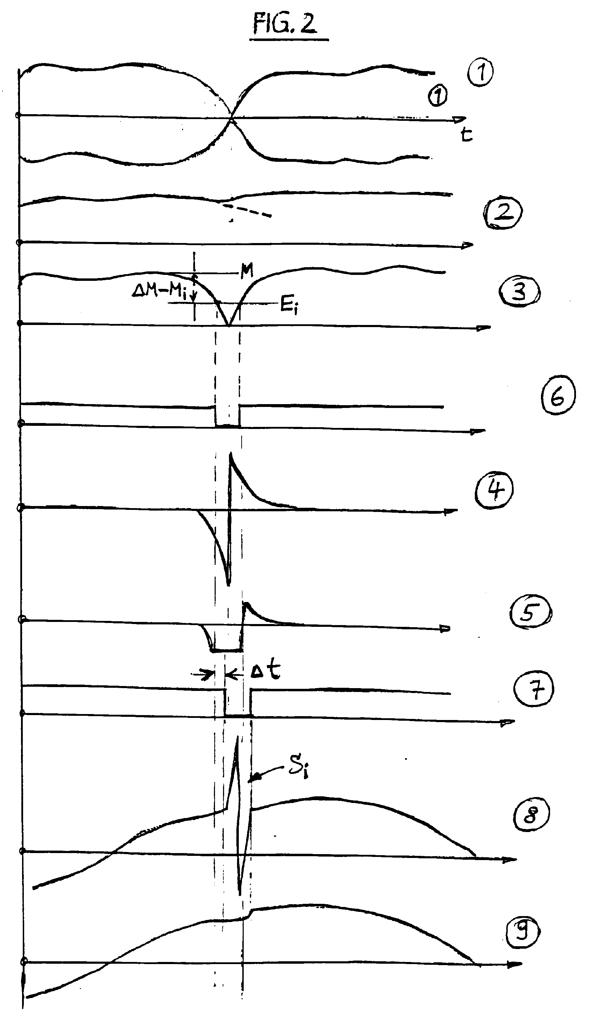

Die eben beschriebenen Funktionen der Schaltung sind anhand der Figur 2 verdeutlicht, wobei die in Kreisen eingeschlossenen Zahlen denjenigen Signalverlauf darstellen, wie er bei den entsprechend gekennzeichneten Leitungsabschnitten innerhalb des Blockschaltbildes der Figur 1 auftritt: Mit "1" ist das Eingangssignal des ZF-Verstärkers bezeichnet, das aufgrund eines Störsignals einen in der Mitte dargestellten Amplitudeneinbruch aufweist (das am Feldstärkeausgang F anstehende Ausgangssignal entspricht qualitativ einer "Hälfte" dieses Signals). Nach der Maximalwertschaltung MAX steht Signal "2", ein flach abfallendes ($\tau$) Spitzenwertsignal am Eingang Y des Komparators KOMP, wogegen im Parallelzweig das Signal "3" auftritt mit dem entsprechenden Amplitudeneinbruch. Aus diesem Amplitudeneinbruch wird nun mit Hilfe der Differenzierschaltung DIFF das Signal "4" (Flankensteilheit) gewonnen, das das Steuersignal "5" bildet, das den Komparator KOMP ansteuert und dort den Schwellenwert $E_i = \Delta M - M_i$ festlegt. Das Ausgangssignal "6" des Komparators KOMP ist folglich ein Rechteckimpuls, der die Verzögerungsschaltung DELAY durchläuft, woraus sich das Signal "7" gleicher Form, aber um eine Zeitspanne $\Delta t$ versetzt, ergibt, das die Sample-and-Holdschaltung SH aktiviert und aus dem Demodulator-Ausgangssignal "8" exakt die Störspitzen $S_i$ ausblendet, in dem während der Korrekturphase das Ausgangssignal "8" des Demodulators DEMOD auf seinem letzten Wert gehalten wird, bis die Sample-and Holdschaltung SH wieder deaktiviert wird.

Die Zeitspanne $\Delta t$ ergibt sich aus der durch die FM-Demodulator-Schaltung verursachte Zeitverzögerung, mit der die Störspitzen typischwerweise verzögert gegenüber dem Feldstärkeeinbruch am Ausgang des FM-Demodulators erscheinen. (Beim FM-Rundfunkempfänger ca. 1 $\mu$S.) Das Wesentliche dieser Schaltung besteht also darin, daß die Dauer der Korrekturphase an das jeweils auftretende Störsignal individuell angepaßt wird und die Erkennung vor dem Auftreten der Störung erfolgt, so daß im Gegensatz zur Störaustastung bekannter Art keine Verzögerung des MPX-Signals erforderlich ist.

Der in Figur 1 mit durchgezogenen Linien skizzierte Aufbau der Sample-and-Hold-Schaltung SH entspricht der üblicherweise verwendeten Grundschaltung: Beim Öffnen des Schalters S wird der Momentanwert des anliegenden Signals durch eine Ladung des Kondensators $C_1$ repräsentiert und die Signalspannung im Öffnungszeitpunkt bleibt am Ausgang stehen. Die in Figur 2 dargestellten Kurvenverläufe stellen einen idealisierten Zustand dar, mit einem definierten Signal und einer deutlich erkennbaren Störung. In der Praxis sind die Signalverläufe sehr viel komplexer und werden beispielsweise durch zusätzliche HF-Signale wie z.B. RDS-Signale überlagert; das bedeutet, daß im Augenblick des Einleitens der Korrekturphase die Amplitude des zu korrigierenden Signals nicht ihren "richtigen" Wert hat, insofern, als beispielsweise der peak eines solchen "schnellen" Zusatzsignals überlagert ist, mit der Folge, daß dann dieser Amplitudenwert über die Dauer der Korrekturphase von der Sample-and-Hold-Schaltung SH gehalten wird. Eine Verbesserung dieser Situation läßt sich dadurch erreichen, daß derart schnelle Signaländerungen eliminiert werden und stattdessen ein Amplitudenmittelwert ständig zur Verfügung gestellt wird, der dann auch in der Korrekturphase das Signal bildet (Beispiel: Im TV-Video-Signal bildet das Helligkeitssignal die "langsame Grundmodulation", das Farbsignal die "schnelle, aufgesetzte" Modulation).

Diese Ausmittelung läßt sich am einfachsten durch den zusätzlich, gestrichelt angedeuteten Widerstand $R_1$ erreichen, wodurch "langsame" Amplitudenänderungen weiterhin den Kondensator $C_1$ aufladen, "schnelle" Amplitudenänderungen lediglich zu einem Mittelwert beitragen. (Die Grenzfrequenz wird durch $R_1$ und $C_1$ bestimmt.)

Für manche Anwendungen, beispielsweise Autoradio-Empfang, ist es wünschenswert, statt des Schalters S einen variablen Widerstand zu verwenden, um ein "weiches" Halten zu erreichen, dies ist in der schematischen Darstellung der Figur 1 durch den parallel liegenden Widerstand $R_{var}$ symbolisiert; in der Praxis können solche Widerstände $R_{var}$ beispielsweise durch FET-Transistoren oder OTAs aufgebaut werden.

Ein weiteres Problem bei einfachen Sample-and-Hold-Anordnungen liegt in der Erzeugung von Störgeräuschen wie z.B. Schaltspikes oder in Offsetproblemen, die den eigentlichen Zweck (die Beseitigung von Interferenzstörungen in der Korrekturphase) ernsthaft gefährden können, beispielsweise bei schwachen Signalpegeln u.U. größere Störimpulse erzeugen als diejenigen, die sie elminieren.

Dieses Problem läßt sich grundsätzlich dadurch lösen, daß anstelle eines Schaltvorgangs am Anfang und am Ende der Korrekturphase ein Überblendvorgang tritt, bei dem das zu unterbrechende Gesamtsignal (bei dem die Störung zu erwarten ist) kontinuierlich durch den vorausgegangenen Signalmittelwert (wie oben erläutert) ersetzt wird. Ein solches Schaltungsbeispiel zeigt Figur 1A: am Mischer P steht das ungeänderte Gesamtsignal und der gebildete Mittelwert $\overline{U}$ an; auf ein Steuersignal S hin (von KOMP) wird das Gesamtsignal U innerhalb einer definierbaren Zeitspanne durch den Mittelwert $\overline{U}$ ersetzt. Hiermit lassen sich preiswerte Lösungen realisieren, die die oben erläuterten Nachteile vermeiden können.

Eine diskrete Lösung für eine geeignete Sample-and-Hold-Schaltung ist in Figur 1 B dargestellt: Verwendet wird ein handelsüblicher "Balanced Modulator" in Bipolartechnik.
Die Funktionsweise dieser Schaltung ist wie folgt:

Widerstände R1 bis R4 und R9 bis R11 dienen in bekannter Weise der Arbeitspunkteinstellung. Kondensatoren C1 und C2 haben die Funktion von Koppelkondensatoren. Am Eingang IN wird über R7 ein Wechselstrom in den Emitter des Transistors Q5 eingespeist. Ist $U_{blend}$ deutlich größer als $U_{Ref}$, so ist der Transistor Q1 durchgeschaltet und der im Transistor Q5 eingespeiste Wechselstrom fließt nahezu vollständig über R5. Bei gleicher Größe von R5 und R7 stehen daher auch gleiche Wechselspannungen an Eingang IN und Ausgang OUT. Der Widerstand R8 und der Kondensator C3 bilden in bekannter Weise einen Tiefpaß. Für Frequenzen weit unterhalb der Grenzfrequenz dieses Tiefpasses R8/C3 ist $V_T$ mit der Spannung am Punkt OUT identisch. Für Frequenzen weit oberhalb der Grenzfrequenz des Tiefpasses R8/C3 bildet $V_T$ den Mittelwert. Über R6 wird ein entsprechender Strom in Q6 eingespeist. Dieser gelangt bei gleicher Lage von $U_{Blend}$ ($U_{Blend} \gg U_{Ref}$) über Q4 ohne weitere Auswirkungen nach $U_{B+}$. Für den Fall $U_{Blend} \ll {}_{Ref}$ kehren sich die Verhältnisse um: Der Eingangsstrom geht über Q5 und Q2 nach $U_{B+}$ und der von $U_T$ abhängige Strom geht über R6, Q6, Q3 und R5 nach OUT. Bei gleicher Größe von R6 und R5 und einer Verstärkung von 1 im OP1 sind die Spannungen $U_{OUT}$ und $U_T$ identisch. Es fließt kein Ausgleichsstrom, das System bleibt auf dem Momentanwert von $U_T$ stehen. Mit P1 werden eventuelle Gleichstromdifferenzen zwischen Q5 und Q6 ausgeglichen, um DC-Offsetstörungen beim Umschalten zu vermeiden.

Es kann natürlich auch jeder Zwischenwert der Stromverteilung mit $U_{Blend}$ eingestellt werden. Entsprechend reduziert erscheint $V_{IN}$ am Ausgang. Von der Eingangsfrequenz, der Überblendgeschwindigkeit und der Grenzfrequenz abhängig wird sich nun eine Ruhelage der Ausgangsspannung einstellen, die bei geeigneter Wahl dem Momentanwert der langsamen Frequenzen und dem Mittelwert der schnellen Frequenzen entspricht.

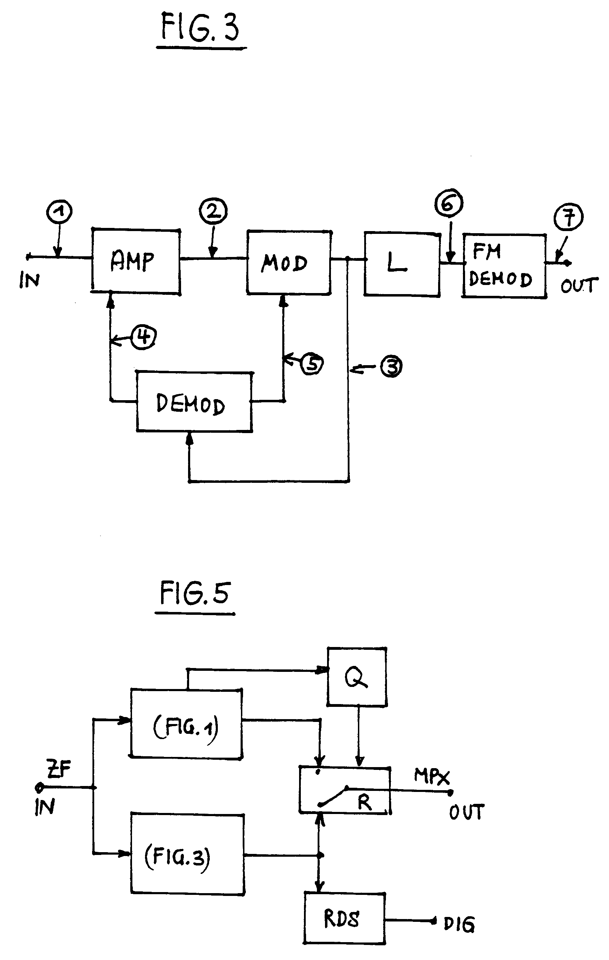

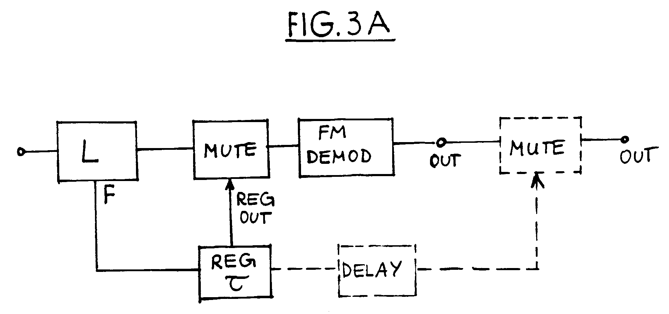

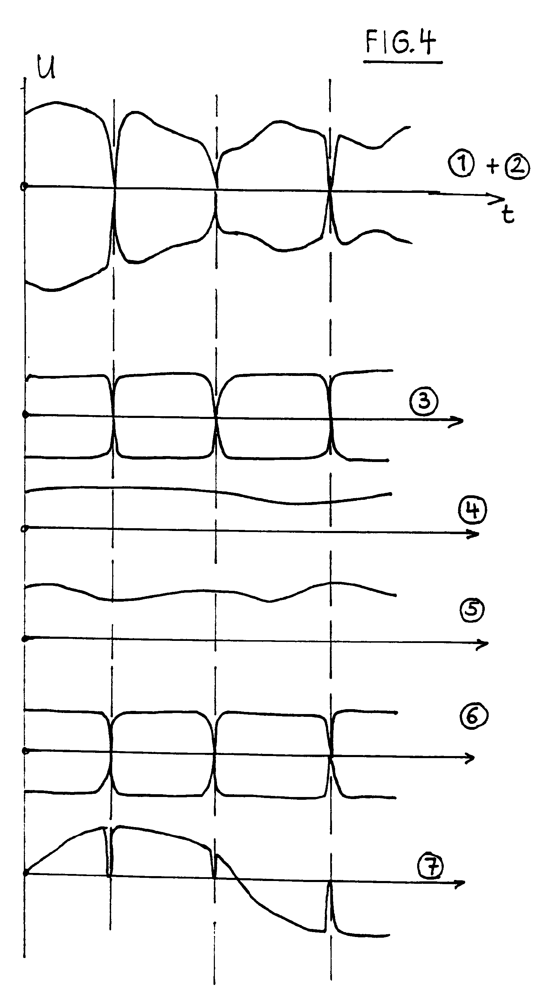

Bei dem in Figuren 3 und 4 dargestellten zweiten Ausführungsbeispiel wird das ZF-Signal "1" in einem Verstärker AMP verstärkt, und die langsamen Feldstärkeschwankungen werden ausgeregelt. In einem nachgeschalteten Modulator MOD werden die schnellen Hüllkurvenschwankungen angesteuert, und ein relativ gering begrenzender Nachbegrenzer L glättet die verbleibende Restwelligkeit, geht jedoch bei größeren Amplitudeneinbrüchen in den linearen Bereich. Extrem tiefe und schnelle Einbrüche der Hüllkurve, von denen drei in Figur 4 dargestellt sind, werden wegen der gering gehaltenen Grenzfrequenz des Modulators MOD nicht ausgeregelt und daher am FM-Demodulator automatisch ausgeblendet; das demodulierte Ausgangssignal "7" weist also in der Korrekturphase anstelle der ohne Austastung auftretenden scharfen Impulsspitzen Signalreduzierungen je nach Einstellung des Nachbegrenzers bis auf das Null-Niveau auf, die sich je nach aktueller Amplitude mehr oder weniger stark bemerkbar machen, jedenfalls aber den Höreindruck wesentlich geringer beeinträchtigen als die ansonsten auftretenden Impulsspitzen. Der langsame geregelte Verstärker AMP und der schnelle Modulator MOD mit der passenden Zeitkonstanten τ sorgen für die unterschiedliche Bewertung der Flankensteilheit, die Maximalpegelregelung sorgt für den richtigen Wert des Bezugspegels. Der nachgeschaltete FM-Demodulator FM-DEMOD kann jeder übliche FM-Demodulator sein, darf jedoch nicht begrenzend im Schalterbetrieb arbeiten. Bei dieser Variante wird auch das Rauschen günstig beeinflußt, indem Amplitudenrauschen reduziert wird und Phasensprünge eliminiert werden.

Weiterhin ist der Demodulator quadratisch von der ZF-Eingangsspannung abhängig, so daß auch bei dieser Alternative ein weiches Schaltverhalten beim Übergang zur Korrekturphase erreicht wird, da der Demodulator progressiv der ZF-Amplitude folgt.

Eine Variante der Schaltung nach Figur 3 zeigt Figur 3A: Hier ist die Reihenfolge von Begrenzer und Modulator vertauscht und der langsame Regler entfällt.

Die Funktion der Schaltung ist folgende:

Heutige ZF-IC haben meist einen logarithmischen Feldstärkeausgang. Damit ist die Einbruchtiefe wie bekannt unabhängig von der absoluten Feldstärke. Ein Regler REG regelt zunächst wie zuvor beschrieben die Maxima auf die Schwelle M ein. Einbrüche der Feldstärke werden mit der Zeitkonstanten τ Richtung M reduziert, die durchgezogene Kurve REG OUT steuert den schnellen Modulator, der üblicherweise an FM Empfängern MUTE genannt wird. Die meisten FM IC haben die Mute-Stufe hinter dem Demodulator (gestrichelt dargestellt). Wegen der unvermeidlichen Laufzeiteffekte muß dann eine Laufzeitkorrektur DEL zwischengeschaltet werden.

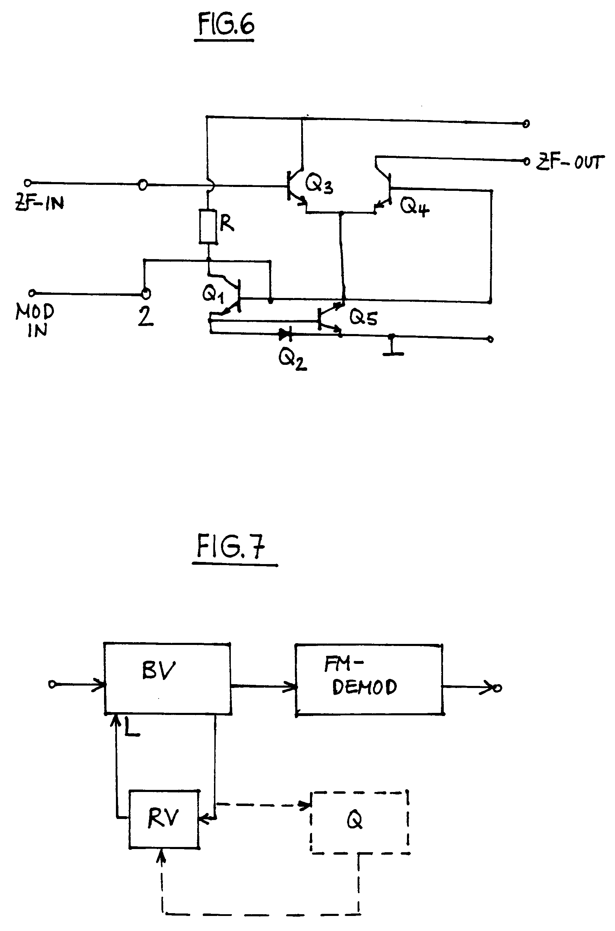

Figur 5 zeigt ein Blockschaltbild einer Kombination der beiden Ausführungsbeispiele gemäß Figuren 1,2 und 3,4, eine Qualitätsbewertungsstufe Q steuert über einen Schalter R das jeweils störungsfreieste MPX-Signal auf dem Ausgang.

Figur 6 zeigt ein Blockschaltbild eines für die Integration in einen integrierten Schaltkreis geeigneten Modulators. Er besteht aus einem Differnezverstärker $Q_3, Q_4$, dessen Steilheit über deren Emitterstrom gesteuert wird. Der Emitterstrom wird vom Anschlußpunkt 2 über eine Stromspiegelschaltung moduliert. Die Arbeitspunkteinstellung erfolgt über den Widerstand R1. Diese Schaltung stellt im Prinzip einen Teil aus einem OTA (Operational Transconductance Amplifier) und kann in der Schaltung gemäß Figur 3 als Begrenzer L und Modulator MOD eingesetzt werden.

6

Die Schaltungsskizze gemäß Figur 7 Zeigt schließlich einen Quasi-Linearverstärker, bei dem der herkömmliche Begrenzer ZF-Verstärker BV über einen Feldstärkeeingang L in der Verstärkung auf einen bestimmten Feldstärkeausgangspegel heruntergeregelt wird. Ein solcher Eingang zur Verstärkungseinstellung ist auch bei einigen ZF-IC vorhanden. Damit ist gesichert, daß bei jedem Feldstärkeeinbruch, der ein bestimmtes Maß übersteigt, der Begrenzer den Begrenzerbetrieb verläßt und in den linearen Betrieb übergeht. Der nachfolgende FM-Demodulator FM-DEMOD wird in diesem Fall, wenn es sich um ein System ohne AM-Unterdrückung handelt, wegen der quadratischen Abhängigkeit der demodulierten Amplitude von der Eingangsspannung durch den Feldstärkeeinbruch automatisch abschalten oder ausblenden; bei dieser Realisierung wird also automatisch die Störphasenmodulation in der ZF-Ebene ausgeblendet. Gestrichelt dargestellt ist eine Qualitätsbewertung Q, mit deren Hilfe die auftretenden Phasenstörungen bewertet werden und die beschriebene "Aushängung" des ZF-Verstärkers nur bei Vorliegen extremer Phasenstörungen aktiviert wird, und die Schaltung ansonsten wie ein üblicher Begrenzerverstärker betrieben wird.

## Patentansprüche

1. Verfahren zur Minimierung von Störungen beim FM- oder PM-Empfang infolge von Interferenzen des Nutzsignals mit Störsignalen, wobei aus dem empfangenen Gesamtsignal eine störungsspezifische Information gewonnen wird, mit deren Hilfe ein Ausgangssignal in einer Korrekturphase zumindest während der Zeitabschnitte maximaler Störung korrigiert wird, wobei als störungsspezifische Information die Dauer eines durch Störsignale verursachten Amplitudeneinbruchs unterhalb eines vorgegebenen Schwellenwertes (E) des Gesamtsignals im Bereich maximalen Störphasengangs zur Steuerung der Dauer der Korrekturphase verwendet wird, dadurch gekennzeichnet, daß der Betrag des Schwellenwertes ($E_i$) während dessen Unterschreitung die Korrektur erfolgt, durch die Steilheit des jeweiligen Amplitudeneinbruchs derart festgelegt wird, daß der Schwellenwert ($E_i$) mit zunehmender Flankensteilheit des Amplitudeneinbruchs automatisch erhöht und die Korrekturphase somit früher eingeleitet-wird, wobei die Einstellung des jeweiligen Schwellenwertes ($E_i$) auch durch den dem Amplitudeneinbruch vorausgehenden Wert (M) des Gesamtsignals festgelegt wird.

2. Verfahren nach Anspruch 1, dadurch gekennzeichnet, daß sich der Schwellenwert ($E_i$) nach folgender Gleichung einstellt:
$$E_i = M - \Delta M + \Delta M_i$$
mit:
$E_i$= individueller Schwellenwert zur Eliminierung der Störung $S_i$
M= Maximalamplitude, die der Störung $S_i$ vorausgeht (Bezugspegel)
$\Delta M$= Grund-Schwellenwert bei Flankensteilheit dF/dt = 0
$\Delta M_i$= Korrekturwert bei Flankensteilheit dF/dt < 0,
so daß bei fest eingestelltem Grund-Schwellenwert ($\Delta M$), der Schwellenwert ($E_i$) mit sinkendem Bezugspegel (M) nach unten, mit zunehmendem Flankenabfall ($-\dot{F}$) nach oben verschoben wird.

3. Verfahren nach Anspruch 1, dadurch gekennzeichnet, daß zur präziseren Steuerung der Schaltschwelle ($E_i$) das Verhältnis von Amplitudeneinbruch $S_i$ zum Bezugspegel (M) durch Verwendung des logarithmischen Feldstärkeausgangs des ZF-Bausteins benutzt wird.

4. Verfahren nach Anspruch 1, dadurch gekennzeichnet, daß während der Korrekturphase das gestörte Signal ausgeblendet und durch das vorher anstehende Signal oder einen Mittelwert desselben ersetzt wird.

5. Verfahren nach Anspruch 1, dadurch gekennzeichnet, daß während der Korrekturphase aufgrund eines Amplitudeneinbruchs der ZF-Hüllkurve die Demodulation des ZF-Signals unterbrochen wird, indem eine lineare Verstärkung vorgeschaltet wird, die bei einem Einbruch der ZF-Hüllkurve diesen Einbruch linear weiterleitet, so daß der FM-Demodulator nicht mehr ausreichend demoduliert.

6. Schaltungsanordnung zur Durchführung des Verfahrens nach Anspruch 1, mit einer Zwischenfrequenzschaltung (ZF-IC) und einer nachgeschalteten Demodulationsschaltung (DEMOD), gekennzeichnet durch folgenden Aufbau zur Minimierung von Störungen:
   a) eine Sample- and Hold-Schaltung (SH), die der Demodulationsschaltung (DEMOD) nachgeschaltet ist und die während der Korrekturphase aktiviert wird,

7

b) eine Parallelschaltung zum Feldstärkeausgang (F) der Zwischenfrequenzschaltung (ZF-IC) und dem Steuereingang (ST) der Sample-and Hold-Schaltung (SH) bestehend aus folgenden Bauteilen:

b1) einem ersten Parallelzweig, bestehend aus einer Maximalwertschaltung (MAX) zur Bildung des Maximalwerts (M) des Gesamtsignals, sowie einer Vergleichsschaltung (KOMP), deren erster Eingang (x) unmittelbar am Feldstärkeausgang (F) liegt, und deren zweiter Eingang (y) mit dem Ausgang der Maximalwertschaltung (MAX) verbunden ist, zur Abgabe des Steuersignals für die Sample-and Hold-Schaltung (SH) genau dann, wenn der aktuelle Feldstärkewert am ersten Eingang (x) um einen vorgegebenen Schwellenwert ($\Delta$M) unter dem Maximalwert (M) am zweiten Eingang (y) liegt, wozu dem zweiten Eingang (y) ein Potential zur Definition dieses Schwellenwerts ($\Delta$M) aufgeprägt ist,

b2) einen zweiten Parallelzweig zur störsignalabhängigen Modifizierung dieses Schwellenwertes ($\Delta$M), bestehend aus einer Differenzierschaltung (DIFF), deren den Flankenabfall (-$\dot{M}$) repräsentierendes Ausgangssignal über eine weitere Sample-and Hold-Schaltung (SH2) an der Vergleichsschaltung (KOMP) anliegt, wo es den Schwellenwert ($\Delta$M) um einen dem Flankenabfall (-$\dot{M}$) entsprechenden Korrekturwert ($\Delta M_i$) erhöht.

7. Schaltungsanordnung nach Anspruch 6, dadurch gekennzeichnet, daß die Sample-and-Hold-Schaltung (SH) eine Reihenschaltung aus Widerstand ($R_1$) und Kondensator ($C_1$) aufweist.

8. Schaltungsanordnung nach Anspruch 6, dadurch gekennzeichnet, daß die Sample-and-Hold-Schaltung (SH) anstelle eines Schaltelementes einen variablen Widerstand ($R_{var}$) oder einen Mischer (P) aufweist, mit dessen Hilfe ein weiches Einblenden bzw. Ausblenden eines Signalmittelwertes zu Beginn bzw. zu Ende der Korrekturphase erfolgen kann.

9. Schaltungsanordnung zur Durchführung des Verfahrens nach Anspruch 1, dadurch gekennzeichnet, daß dem FM-Demodulator (FM-DEMOD) ein schneller Regelverstärker (MOD) vorgeschaltet ist, der niederfrequente Schwankungen der ZF-Hüllkurve ausregelt, sowie ein langsamer Regelverstärker (AMP), der langsame Feldstärkeschwankungen ausregelt.

10. Schaltungsanordnung nach Anspruch 9, dadurch gekennzeichnet, daß dem Regelverstärker (AMP) und/oder (MOD) ein Begrenzer (L) mit schwacher Begrenzung nachgeschaltet ist, der restliche Hüllkurvenschwankungen glättet, jedoch die Ausblendung bei tiefen Einbrüchen der Hüllkurve nicht behindert.

## Claims

1. Method of minimising interference during FM or PM reception as a consequence of interference of an information signal with interference signals, interference-specific information being obtained from the total signal received, by means of which information an output signal is corrected in a correction phase at least during the time periods of maximum interference, the duration of an amplitude dip below a prescribed threshold value (E) of the total signal, caused by interference signals, in the range of the maximum interference phase cycle, being used as the interference-specific information for controlling the duration of the correction phase, characterised in that the magnitude of the threshold value ($E_i$), below which the correction is effected, is determined by the slope of the respective amplitude dip in such a way that the threshold value ($E_i$) is automatically increased with increasing edge slope of the amplitude dip, and in this way the correction phase is initiated earlier, the setting of the respective threshold value ($E_i$) also being determined by the value (M) of the total signal preceding the amplitude dip.

2. Method according to claim 1, characterised in that the threshold value ($E_i$) is set according to the following equation:

$$E_i = M - \Delta M + \Delta M_i$$

with:

$E_i$ = individual threshold value for eliminating the interference $S_i$,

$M$ = maximum amplitude, which precedes the interference $S_i$ (reference level),

$\Delta M$ = basic threshold value with edge slope dF/dt=0,

$\Delta M_i$ = correction value with edge slope dF/dt<0,

so that, with a firmly set basic threshold value ($\Delta M$), the threshold value ($E_i$) is downwardly displaced with a dropping reference level (M) and upwardly displaced with an increasing negative edge slope (-$\dot{F}$).

3. Method according to claim 1, characterised in that the ratio of amplitude dip ($S_i$) to the reference level (M) is used for the more precise control of the switching threshold ($E_i$) by employing the logarithmic field strength output of the IF component.

4. Method according to claim 1, characterised in th6at, during the correction phase, the faulty signal is blanked out and replaced by the previously present signal or a mean value of such.

5. Method according to claim 1, characterised in that, during the correction phase, the demodulation of the IF signal is interrupted because of an amplitude dip of the IF envelope curve, in that a linear amplifier is connected upstream thereof which, if there is a dip in the IF envelope curve, transmits this dip linearly so that the FM demodulator is no longer sufficiently demodulated.

6. Circuit arrangement for executing the method according to claim 1, having an intermediate frequency circuit (IF-IC) and a demodulation circuit (DEMOD) connected to the output thereof, characterised by the following structure for minimising interference:
   a) a sample and hold circuit (SH), which is connected to the output of the demodulation circuit (DEMOD), and which is activated during the correction phase,
   b) a circuit in parallel with the field strength output (F) of the intermediate frequency circuit (IF-IC) and the control input (ST) of the sample and hold circuit (SH), comprising the following components:
   b1) a first parallel branch, comprising a maximum value circuit (MAX) for forming the maximum value (M) of the total signal, and a comparator circuit (COMP), the first input (x) of which is directly connected to the field strength output (F), and the second input (y) of which is connected to the output of the maximum value circuit (MAX), for issuing the control signal for the sample and hold circuit (SH) exactly when the actual field strength value at the first input (x) is below the maximum value (M) at the second input (y) by a prescribed threshold value ($\Delta M$), for which purpose a potential for defining this threshold value ($\Delta M$) is superimposed on the second input (y),
   b2) a second parallel branch for modifying this threshold value ($\Delta M$) in dependence on the interference signal, comprising a differentiating circuit (DIFF), the output signal of which represents the negative edge slope ($-\dot{M}$) and is applied to the comparator circuit (COMP) via an additional sample and hold circuit (SH2), where it increases the threshold value ($\Delta M$) by a correction value ($\Delta M_i$), which corresponds to the negative edge slope ($-\dot{M}$)

7. Circuit arrangement according to claim 6, characterised in that the sample and hold circuit (SH) has a series circuit comprising resistor ($R_1$) and capacitor ($C_1$).

8. Circuit arrangement according to claim 6, characterised in that the sample and hold circuit (SH) has a variable resistor ($R_{var}$) or a mixer (P) instead of a switching element, by means of which resistor or mixer a smooth fading-in or blanking-out of a mean signal value can take place at the beginning or end respectively of the correction phase.

9. Circuit arrangement for executing the method according to claim 1, characterised in that a rapid control amplifier (MOD) is connected upstream of the FM demodulator (FM-DEMOD) and compensates for low-frequency fluctuations of the IF envelope curve, and a slow control amplifier (AMP) is connected upstream of the FM demodulator (FM-DEMOD) and compensates for slow field strength fluctuations.

10. Circuit arrangement according to claim 9, characterised in that a limiter (L) is connected downstream of the control amplifier (AMP) and/or (MOD), which limiter has slight limitation and smooths remaining envelope curve fluctuations, but it does not hinder the blanking-out if there are deep dips of the envelope curve.

## Revendications

1. Procédé de réduction du bruit à la réception FM ou PM dû à la superposition de signaux parasites au signal utile, dans lequel est extraite du signal total reçu une information propre au bruit à l'aide de laquelle un signal de sortie est corrigé dans une phase de correction au moins pendant les périodes de bruit maximal, comme information propre au bruit étant utilisée, pour la commande de la durée de la phase de correction, la durée d'une chute d'amplitude provoquée par les signaux parasites au-dessous d'un seuil fixé (E) du signal total dans la zone de réponse en phase de bruit maximale,
caractérisé par le fait que la valeur du seuil ($E_i$) au-dessous duquel la correction a lieu est fixée par la raideur de la chute d'amplitude de façon telle que le seuil ($E_i$) soit relevé automatiquement lorsque la raideur du flanc de la chute d'amplitude augmente et que le phase de correction soit ainsi déclenchée plus tôt, le réglage du seuil ($E_i$) étant aussi fixé par la valeur (M) du signal total précédant la chute d'amplitude.

2. Procédé selon la revendication 1, caractérisé par le fait que le seuil ($E_i$) se règle selon la relation suivante :

$$E_i = M - \Delta M + \Delta M_i$$

avec :

$E_i$ = seuil individuel pour l'élimination du bruit $S_i$

$M$ = amplitude maximale précédant le bruit $S_i$ (niveau de référence)

$\Delta M$ = seuil de base pour une raideur du flanc dF/dt = 0

$\Delta M_i$ = correction pour une raideur du flanc dF/dt < 0,

de sorte que lorsque le seuil de base ($\Delta M$) est réglé à une valeur fixe, le seuil ($E_i$) est déplacé vers le bas lorsque le niveau de référence (M) baisse et vers le haut lorsque la pente du flanc (- $\dot{F}$) augmente.

3. Procédé selon la revendication 1, caractérisé par le fait que pour une commande plus précise du seuil de commutation ($E_i$) est employé le rapport de la chute d'amplitude ($S_i$) au niveau de référence (M) par utilisation de la sortie d'intensité de champ logarithmique du bloc FI.

4. Procédé selon la revendication 1, caractérisé par le fait que pendant la phase de correction, le signal perturbé est supprimé et remplacé par le signal existant précédemment ou par une valeur moyenne de celui-ci.

5. Procédé selon la revendication 1, caractérisé par le fait que pendant la phase de correction sur la base d'une chute d'amplitude de l'enveloppe FI, la démodulation du signal FI est interrompue par l'établissement en amont d'une amplification linéaire qui, lors d'une chute de l'enveloppe FI, transmet linéairement cette chute, de sorte que le démodulateur FI ne démodule plus suffisamment.

6. Montage pour la mise en oeuvre du procédé selon la revendication 1, comportant un circuit à fréquence intermédiaire (CI FI) et un circuit démodulateur (DEMOD) monté en aval de celui-ci, caractérisé par la constitution suivante pour la réduction au minimum du bruit :

a) un circuit échantillonneur (SH) monté en aval du circuit démodulateur (DEMOD) et mis en action pendant la phase de correction,

b) un circuit parallèle sur la sortie d'intensité de champ (F) du circuit à fréquence intermédiaire (CI FI) et l'entrée de commande (ST) du circuit échantillonneur (SH), constitué des éléments suivants :

b1) une première branche parallèle constituée d'un circuit de valeur maximale (MAX) pour l'établissement de la valeur maximale (M) du signal total, et d'un circuit comparateur (COMP) dont la première entrée (x) est reliée directement à la sortie d'intensité de champ (F) et la deuxième entrée (y) reliée à la sortie du circuit de valeur maximale (MAX), pour l'émission du signal de commande du circuit échantillonneur (SH) exactement lorsque l'intensité de champ actuelle à la première entrée (x) est inférieure d'un seuil fixé ($\Delta M$) à la valeur maximale (M) à la deuxième entrée (y), à la deuxième entrée (y) étant pour cela appliqué un potentiel pour la définition de ce seuil ($\Delta M$),

b2) une deuxième branche parallèle pour la modification en fonction du signal parasite de ce seuil ($\Delta M$), constituée d'un circuit différentiateur (DIFF) dont le signal de sortie, représentant la pente du flanc (- $\dot{M}$), est envoyé par l'intermédiaire d'un autre circuit échantillonneur (SH2) au circuit comparateur (COMP), où il relève le seuil ($\Delta M$) d'une valeur de correction ($\Delta M_i$) correspondant à la pente du flanc (- $\dot{M}$).

7. Montage selon la revendication 6, caractérisé par le fait que le circuit échantillonneur (SH) présente un circuit série constitué d'une résistance (R1) et d'un condensateur (C1).

8. Montage selon la revendication 6, caractérisé par le fait que le circuit échantilloneur (SH) présente au lieu d'un élément de commutation une résistance variable ($R_{var}$) ou un mélangeur (P) à l'aide de laquelle ou duquel une insertion ou une suppression douce d'une valeur moyenne de signal peut être effectuée respectivement au début ou à la fin de la phase de correction.

9. Montage pour la mise en oeuvre du procédé selon la revendication 1, caractérisé par le fait qu'en amont du démodulateur FM (DEMOD FM) sont montés un amplificateur régulateur rapide (MOD) qui élimine les fluctuations à basse fréquence de l'enveloppe FI et un amplificateur régulateur lent (AMP) qui élimine les fluctuations lentes de l'intensité de champ.

10. Montage selon la revendication 9, caractérisé par le fait qu'en aval de l'amplificateur régulateur (AMP) et/ou de l'amplificateur régulateur (MOD) est monté un limiteur (L) à limitation faible qui lisse les fluctuations restantes de l'enveloppe, mais ne gêne pas la suppression aux chutes profondes de l'enveloppe.

FIG.1

FIG.1A

FIG. 1B

EP 0 475 188 B1

## FIG. 2

## FIG.3

## FIG.5

## FIG. 3 A

FIG.4

## FIG.6

## FIG.7